# EUROPÄISCHE PATENTSCHRIFT

(11) **EP 0 530 176 B1**
(45) Veröffentlichungstag und Bekanntmachung des Hinweises auf die Patenterteilung: **25.09.1996**
(21) Anmeldenummer: 92890185.9
(22) Anmeldetag: 20.08.1992
(51) Int. Cl.: G01D 5/249, H03M 1/22

(54) **Längen- oder Winkelmesssystem**
Length or angle measuring system
Dispositif de mesure linéaire ou angulaire

(30) Priorität: 23.08.1991 AT 1661/91; 22.11.1991 AT 2322/91; 05.03.1992 AT 418/92; 13.07.1992 AT 1429/92
(43) Veröffentlichungstag der Anmeldung: 03.03.1993
(73) Patentinhaber: RSF-Elektronik Gesellschaft m.b.H., A-5121 Tarsdorf 93 (AT)
(72) Erfinder: Rieder, Heinz, A-5110 Oberndorf (AT); Schwaiger, Max, A-5121 Ostermiething (AT)
(74) Vertreter: Hübscher, Helmut, Dipl.-Ing.

(56) Entgegenhaltungen:
- EP-A- 0 121 658
- EP-A- 0 503 716
- DE-A- 3 337 653
- DE-A- 3 939 147
- DE-C- 2 619 494
- GB-A- 2 126 444
- JOURNAL OF PHYSICS E. SCIENTIFIC INSTRUMENTS Bd. 21, Nr. 12, Dezember 1988, BRISTOL GB Seiten 1140 - 1145 STEVENSON ET AL 'absolute position measurement using optical detection of coded patterns'

## Beschreibung

Die Erfindung betrifft ein Längen- oder Winkelmeßsystem nach dem Oberbegriff des Patentanspruches 1.

Ein derartiges Längen- oder Winkelmeßsystem ist aus der DE-C 26 19 494 bekannt. Dabei ist jedes Codewort der seriellen Strichcodierung mit einem einleitenden Merkmal versehen, das für alle Codewöter gleich bleibt. Für die Ablesung dient ein vielzeiliger Detektor. Ein bestimmter Absolutmeßwert ist durch das jeweils erfaßte Codewort und die Lage des einleitenden Merkmales dieses Codewortes zum Detektor definiert. In der Praxis ist dieses Meßsystem nur theoretisch brauchbar. Es ist nämlich eine optische Abbildung des jeweiligen Maßstabteilstückes mittels Linse oder Objektiv auf die Ableseeinheit notwendig, so daß sich eine aufwendige Gesamtkonstruktion ergibt. Eine einwandfreie Anzeige kann im wesentlichen nur bei relativ zum Meßsystem stillstehender Abtasteinheit erzielt werden. Die mögliche bzw. zulässige Verstellgeschwindigkeit beim Meßvorgang muß äußerst gering gehalten werden und die tatsächlich mögliche Auflösung ist wesentlich geringer als bei anderen Meßsystemen, nämlich den sogenannten inkrementalen Meßsystemen. Ein grundsätzlicher Nachteil des Meßsystems besteht außerdem darin, daß es nur mit besonders ausgelegten Auswertungseinheiten brauchbar ist, also nicht in bestehende Meß- und Auswertungssysteme, z.B. Steuerungen, integriert werden kann, die nur Eingänge für von inkrementalen Meßsystemen stammende Zähl- und Referenzsignale aufweisen.

Es gibt auch Absolutmeßsysteme mit in vielen Parallelspuren vorgesehenen Codierungsmerkmalen, die beispielsweise nach dem sogenannten Gray-Code codiert sind, wobei für jede Einzelspur eine eigene Abtasteinheit erforderlich ist und die parallel abgelesenen Abtastsignale unmittelbar die Momentanposition der Abtasteinheit angeben. Wenn bei solchen Absolutsystemen nur auf 0,01 mm genau abgelesen werden soll, werden bei einer Meßlänge von 500 mm 16 Spuren mit entsprechenden Abtasteinheiten benötigt, so daß breite Maßstabe und aufwendige Abtasteinheiten erforderlich werden und Ableseungenauigkeiten durch Verkantungsfehler der Ableseeinheiten gegenüber dem breiten Maßstab auftreten. Dabei kann die am feinsten auflösende Spur des Absolutmaßstabes mit einer Inkrementalteilung versehen werden, die nach bei inkrementalen Meßsystemen bekannten Abtastprinzipien abgetastet wird, um so eine höhere Auflösung zu erzielen, wobei diese Auflösung aber immer noch wesentlich geringer ist als bei bekannten inkrementalen Meßsystemen.

Bei Inkrementalmeßsystemen, die sich durch einfach herstellbare Maßstäbe mit schmaler Meßteilung, einfache Abtasteinheiten und hohes erzielbares Auflösungsvermögen auszeichnen, ist es bekannt, dadurch absolute Messungen zu ermöglichen, daß in eigenen Spuren Referenzmarken vorgesehen werden, deren Lage der Inkrementalspur absolut zugeordnet ist und die nach verschiedenen Verfahren identifiziert werden können, so daß jeder Meßpunkt durch seinen bei der Inkrementalmessung erfaßten Abstand von der letzten identifizierten Referenzmarke absolut bestimmt ist. Die Referenzmarken können nach der EP-A 0 121 685 durch in der gleichen oder in eigenen Codespuren angebrachte Codewörter identifiziert werden, die dann unter Erhöhung des Gesamtaufwandes über eigene Ableseeinrichtungen ablesbar sind. Es ist auch bekannt, eine sogenannte Abstandscodierung der Referenzmarken vorzusehen, bei der jede Referenzmarke durch unterschiedliche Abstände von den beiden benachbarten Referenzmarken absolut definiert ist und durch Messung dieses Abstandes identifiziert werden kann. Ein Beispiel für die Abstandscodierung der Referenzmarken entnimmt man der DE-C 24 16 212. Nachteilig ist, daß zur Bestimmung der Momentanposition der Abtasteinheit gegenüber dem Maßstab z.B. bei Meßbeginn oder nach Betriebsunterbrechungen ein Anfahren von wenigstens einer, meist aber von zwei Referenzmarken und dann eine Rückkehr zum vorher eingenommenen Meßpunkt notwendig ist. Neben dem erhöhten Betriebs- und Einstellungsaufwand hat diese Vorgangsweise bei Verwendung der Meßsysteme z.B. in Kombination mit Steuerungsanlagen von Werkzeugmaschinen und Robotern den grundsätzlichen Nachteil, daß sichergestellt werden muß, daß allenfalls in Eingriff befindliche Werkzeuge der Bearbeitungsmaschine und bzw. Teile des Roboters deren Bewegung über das Meßsystem überwacht wird, sich bei dieser für die Ermittelung der Absolutposition notwendigen Verstellung nicht selbst oder das jeweilige Werkstück beschädigen.

Aufgabe der Erfindung ist die Schaffung eines Meßsystems, das mit einer einfachen Ausbildung des Maßstabes, einfachen Abtasteinheiten und einer einfachen Auswertungsschaltung das Auslangen findet, eine hinreichend genaue Absolutmessung ohne Verstellung der Abtasteinheit zur Gewinnung bzw. Wiedergewinnung der Momentanposition ermöglicht und dabei trotzdem auch hohe Verstellgeschwindigkeiten der Abtasteinheit beim Meßvorgang zuläßt. Eine Teilaufgabe der Erfindung besteht darin, ein Meßsystem zu schaffen, das bei nur Eingänge für Inkrementalteile aufweisenden Auswertungs- und Steuereinrichtungen ohne Änderung dieser Einrichtungen das ursprünglich vorgesehene inkrementale Meßsystem ersetzen kann.

Die gestellte Aufgabe wird durch die Merkmale des Patentanspruches 1 vollständig gelöst. Der absolut codierte Teil des Maßstabes und die zugehörige Ableseeinrichtung wird zur Bestimmung einer Momentanposition eingesetzt, wobei ein feines Auflösungsvermögen dadurch erzielt wird, daß eine eindeutige Beziehung zwischen der Messung an Absolutmaßstab und der momentanen Abtaststelle am Inkrementalmaßstab hergestellt wird. Für die laufende Messung wird das bekannte hohe Auflösungsvermögen und die zulässige hohe Verstellgeschwindigkeit des Inkrementalmeßsystems ausgenutzt, wobei auch elektronische Unterteilungen eines Inkrementalmaßstabes, z.B. durch Interpolation, möglich sind. Die jeweilige Absolutposition bei Meßbeginn oder nach Betriebsunterbrechungen wird bzw. kann ohne Relativverstellung der Abtasteinheit zum Maßstab ermittelt werden.

Die Herstellung einer eindeutigen Beziehung der grob am absolut codierten Teil des Maßstabes erfaßten Position zur Inkrementalmessung wird durch eine Ausführung gemäß Anspruch 2 mit einfachen Mitteln möglich. Dabei kann man bei der Weiterbildung nach Anspruch 3 einen Meßpunkt sogar mit hinreichender Genauigkeit innerhalb der Pixelbreite festlegen. Man kann aber auch eine Absolutcodierung mit ineinander verschachtelten Codewörtern einsetzen, wobei dann vorzugsweise eine genau definierte Signalflanke aus der Abtastung eines absolut codierten Codewortes die Beziehung zum Meßpunkt auf der Inkrementalteilung herstellt.

Eine bevorzugte Ausführung ist in Anspruch 4 angegeben. Dabei ist es nicht notwendig, die Teilung der Inkrementalteilung auf die Grundteilung der Absolutcodierung abzustimmen. Für beide Meßteilungen wird nur eine schmale Spurbreite benötigt, wobei dadurch, daß der fortlaufende Meßvorgang auf die Inkrementalmessung bezogen wird, Verkantungsfehler weitgehend unterdrückt werden.

Um eindeutige Angaben bei der Abtastung der Absolutteilung zu erhalten, empfiehlt sich eine Bemessung der Absolutcodierung nach Anspruch 5, wobei die Ablesegenauigkeit durch eine Weiterbildung gemäß Anspruch 6 noch erhöht werden kann. Durch die Verwendung von räumlich kohärenten Licht wird die Ablesegenauigkeit weiter erhöht. Dabei kann gemäß Anspruch 7 vogegangen werden. Abhängig von den verwendeten Detektoren kann mit gepulstem Licht oder mit Dauerlicht gearbeitet werden.

Die Ansprüche 8 - 12 geben verschiedene Möglichkeiten an, um die Ablesegenauigkeit zu erhöhen und eine Anpassung an verschiedene zur Verfügung stehende Abtasteinrichtungen zu ermöglichen. Durch unterschiedliche Abtastabstände bei photoelektrischer Abtastung kann die Abstandstoleranz für die Abtastung der Inkrementalteilung vergrößert werden und es lassen sich durch Einhaltung definierter Abtastabstände günstige Signalformen der Meßsignale erzielen. Eine weitere Möglichkeit zur Erhöhung der Ablesegenauigkeit für die codierte Meßteilung ist in Anspruch 13 angegeben.

Ein wesentlicher Vorteil des erfindungsgemäßen Meßsystems besteht darin, daß es mit einfachen Mitteln so gestaltet werden kann, daß es anstelle eines herkömmlichen Inkrementalmeßsystemes einsetzbar wird, wobei aber für die Gewinnung der Absolutposition bei Meßbeginn oder nach Betriebsunterbrechungen bzw. im Falle periodischer Überprüfungen keine Relativverstellung der Abtasteinheit gegenüber dem Maßstab benötigt wird. Zur Erzielung dieser Vorteile wird eine grundsätzlich in Anspruch 14 angegebene Anpassungsschaltung verwendet. Hier kann man über eine vorhandene Schnittstelle Zähl- und Steuereinrichtungen, die ausschließlich Eingänge für Inkrementalsignale aufweisen, mit den entsprechenden Signalen beaufschlagen. Übliche Steuerungen und Meßeinrichtungen haben bei einer Neueinschaltung Anlaufzeiten von mehreren Sekunden, die man für die Übertragung der Positionssignale von der Anpassungsschaltung zur Auswertungseinheit ausnützt.

Eine bevorzugte Ausbildung der Anpassungsschaltung ist in Anspruch 15 angegeben. Man kann zusätzliche diese Anpassungsschaltung mit Signalformerstufen ausstatten, die die Inkrementalsignale in die für die jeweilige Auswertungseinheit geeignete, z.B. digitale Form bringen.

Für den Fall, daß zumindest theoretisch die Möglichkeit einer Relativverstellung von Abtasteinheit und Maßstab nach der Ersterfassung der Absolutposition und während der Signalübertragung zur Steuereinrichtung vorhanden ist, wird eine Ausbildung gemäß Anspruch 16 vorgesehen.

Bei Anzeige- und Steuereinrichtungen, die für den Empfang von Referenzsignalen eingerichtet sind, kann man die Anpassungsschaltung gemäß Anspruch 17 ausbilden, so daß an wählbaren bzw. festgelegten Maßstabstellen beim Überfahren durch die Abtasteinheit Referenzsignale erzeugt werden, ohne daß dort tatsächlich eine Referenzmarke vorhanden ist. Form und Dauer der Referenzsignale kann im vom Rechner der Anpassungsschaltung ansteuerbaren Speichern bzw. eigenen Signalformerstufen festgelegt werden.

Im Bedarfsfall kann man auch gemäß Anspruch 18 eine Abstandscodierung der erzeugten Referenzsignale wählen, wobei dann eine Ausführung gemäß Anspruch 19 ermöglicht wird, wodurch eine entsprechende Empfängerschaltung der Auswertungseinheit ausgenützt werden kann und auch die Übertragungszeiten für die Eingabe der momentanen Absolutposition in die Empfängerschaltung wesentlich verkürzt werden.

Eine Ausführung nach Anspruch 20 ermöglicht es, bei dem vorhandenen Absolutsystem trotzdem die Absolutmessung auf einen beliebig wählbaren Maßstabnullpunkt, z.B. den Nullpunkt einer Werkzeugmaschine, zu beziehen.

Weitere Einzelheiten und Vorteile des Erfindungsgegenstandes entnimmt man der nachfolgenden Zeichnungsbeschreibung.

In der Zeichnung ist der Erfindungsgegenstand beispielsweise veranschaulicht. Es zeigen
- Fig. 1: in schematischer Darstellungsweise ein Blockschema einer ersten Ausführungsform eines erfindungsgemäßen, als Längenmeßsystem ausgebildeten Meßsystems,
- Fig. 2: ein Diagramm, in dem bei der Abtastung auftretende Meßsignale angedeutet sind,
- Fig. 3: ein weiteres Diagramm der absoluten Meßsignale,
- Fig. 4: in stark vergrößerter und vereinfachter Darstellungsweise übereinander die Teilung eines Zeilendetektors in Zuordnung zu einem Teilstück einer seriell codierten Meßteilung,
- Fig. 5: wieder im Blockschema eine dritte Ausführungsform eines Längenmeßsystems,
- Fig. 6: ebenfalls im Blockschema ein Längenmeßsystem mit einer Anpassungsschaltung für die Signalabgabe an eine nur Eingänge für Inkrementalsignale aufweisende Anzeige- oder Steuereinheit,
- Fig. 7: eine Ausführungsvariante für den Rechner nach Fig.6 und
- Fig. 8: im Schema Signalzüge, die zur Kennzeichnung eines Meßpunktes bei der Verwendung von durch Speicherwerte definierten, abstandscodierten Referenzmarken von der Anpassungsschaltung an die Auswertungseinheit zu übertragen sind.

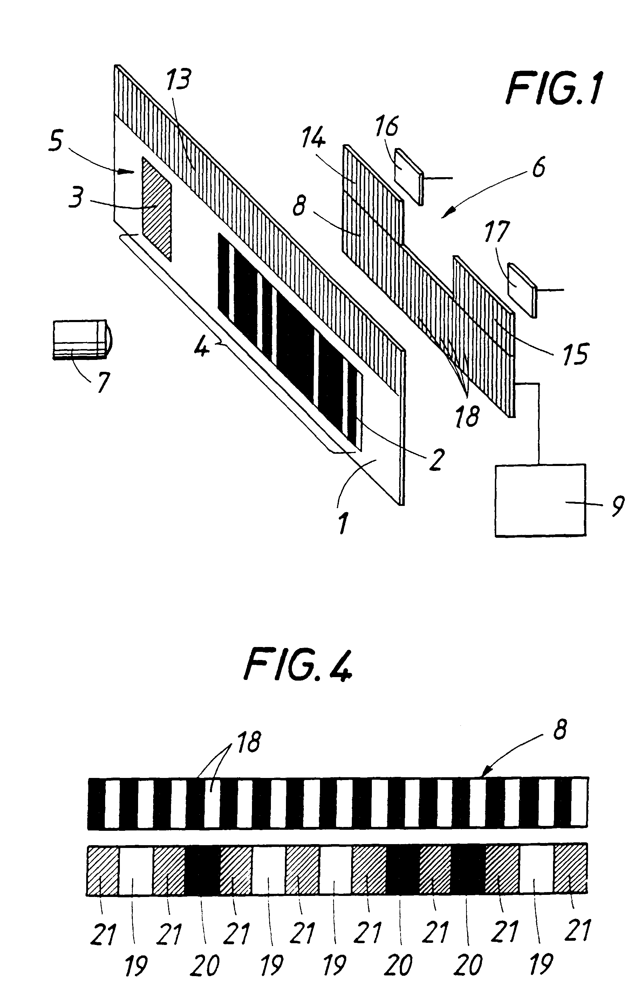

Bei der Ausführungsform nach Fig. 1 ist ein transparenter Maßstabkörper 1 vorhanden, der eine absolute Meßteilung aufweist, die jeweils aus in serieller Codierung angebrachten, jede bestimmte Maßstabstelle kennzeichnenden Codeworten 2 und zugehörigen Startzeichen 3 besteht. Am Maßstab 1 folgen entsprechende, aus den Feldern 2 und 3 gebildete Gruppen 4 vorzugsweise in gleichbleibender Grundteilung aufeinander, wobei sich diese Gruppen 4 nur durch die sich ändernde, die jeweilige Maßstabstelle innerhalb der Meßteilung 5 kennzeichnende Codierung des Codewortes 2 unterscheiden.

Für die Abtastung der absolut codierten Meßteilung 5 dient eine relativ zum Maßstab 1 in Längsrichtung verstellbare Abtasteinheit 6, die aus einer Beleuchtungseinrichtung 7, einem CCD-Chip 8 und einer Auswertungseinheit 9 gebildet ist. Die Beleuchtungseinrichtung 7 kann aus einer Lampe mit Collimatorlinse bestehen, aber auch von einer oder mehreren Leuchtdioden, Laserdioden, oder sonstigen, für die Beleuchtung der jeweiligen Maßstabstelle und insbesondere für Parallellicht geeigneten Lichtquelle gebildet werden. Die Beleuchtungseinrichtung 7 kann im Pulsbetrieb oder mit Konstantlicht arbeiten.

Der CCD-Chip 8 wurde verkürzt dargestellt und besitzt tatsächlich eine Länge, die z.B. über zwei vollständige Gruppen 4 reicht und gewährleistet, daß in jeder Stellung der Abtasteinheit 6 wenigstens eine Gruppe 4 seriell erfaßt werden kann. In den einzelnen Pixelelementen im CCD-Chip treten unterschiedliche Signale auf, je nachdem, in welchem Abtastbereich sich der Chip 8 gegenüber der Absolutspur 5 befindet. Es werden unterschiedliche Signale vom Startzeichen 3 und vom Codewort 2 erhalten.

In einer Parallelspur zur absolut codierten Spur 5 ist eine durchgehende Inkrementalteilung 13 vorgesehen. Auf der Abtasteinheit 6 sind zusätzlich zum CCD-Chip 8 Abtastgitter 14, 15 um Teilungsbruchteile versetzt angebracht und diesen Gittern sind Abtastelemente 16, 17 zugeordnet, die beim Ausführungsbeispiel von der gemeinsamen Beleuchtungseinrichtung 7 beleuchtet werden und der Momentanstellung der Gitter 14, 15 gegenüber der Inkrementalteilung entsprechende Signale bzw. während der Bewegung der Abtasteinheit 6 sinusförmige Analogsignale erzeugen, die gegeneinander phasenverschoben sind.

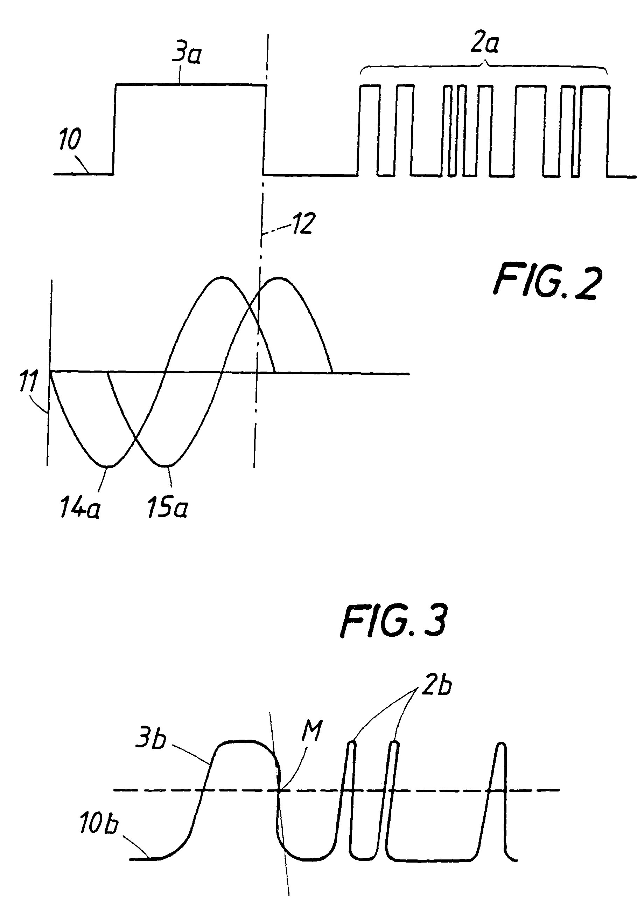

In Fig. 2 sind in der Kurve 10 die im Stillstand im Chip 8 auftretenden Signale 3a aus den Startzeichen 3 und mit 2a die aus dem Codewort 2 erhaltenen Signale dargestellt. Die Kurve 11 zeigt die durch Abtastung der Inkrementalteilung 13 erhaltenenen Analogsignale 14a, 15a. Dadurch, daß beim Auslesen des Detektors 8 die Lage des Startzeichens 3 z.B. durch Zählen der Zeilenimpulse des Detektors bis zum Auftreten der das Startzeichen 3 kennzeichnenden Bitkombination bestimmt wird und anschließend das Codewort 2 ausgelesen wird, wird die Lage des Detektors 8 zum Maßstab 1 grobstufig erkannt. Eine Bestimmung der Phasenlage der Inkrementalspursignale 14a, 15a nach der als Bezug gewählten Endflanke des Signales 3a (Bezugslinie 12) ergibt die feinstufige Bestimmung der Lage des Detektors 8 innerhalb einer Pixelbreite. Durch Bestimmung der Phasenlage der Inkrementalspursignale 14a, 15a läßt sich eine Bestimmung des momentanen Meßpunktes mit einer Genauigkeit von Mikrometerbruchteilen erzielen. Bezieht man nach der Bestimmung der Absolutposition die Messung auf die Abtastung der Inkrementalteilungen unter bekannter Interpolationsunterteilung oder sonstiger elektronischer Unterteilung, so kann man ebenfalls eine Anzeigegenauigkeit in Bruchteilen von Mikrometern erreichen.

In Fig. 2 wurde die Kurvenform der Signale 2a, 3a idealisiert dargestellt. In der Praxis wird man insbesondere in Zwischenstellungen, wo nicht jedes Pixel des Chips exakt auf eine Zeile der Absolutcodierung ausgerichtet ist, gemäß Fig. 3 eine Kurvenform 2b, 3b in der Kurve 10b erhalten. Durch die durch eine Schräglinie angedeutete Kantenauswertung und durch Vorgabe eines als strichpunktierte Linie eingezeichneten Triggerpegels kann man innerhalb der Pixelbreite eine exakte Zuordnung des Meßpunktes M und damit schon an der Absolutteilung eine Auflösung bis in den Mikrometerbereich erzielen, wobei man die Bezugslinie 12 sinngemäß auf den Meßpunkt M bezieht. Im Zweifelsfall wird in der Auswertungseinheit den Signalen 14a, 15a bzw. deren Auswertung Vorrang gegeben, die Signale 14a, 15a entscheiden also in einer Mittelstellung des CCD-Chips gegenüber den Zeilen eines Codewortes, welchem Zeilenrand die momentane Zwischenstellung zugeordnet wird. Die Breite der Codierungsbits soll größer als die Pixelbreite sein.

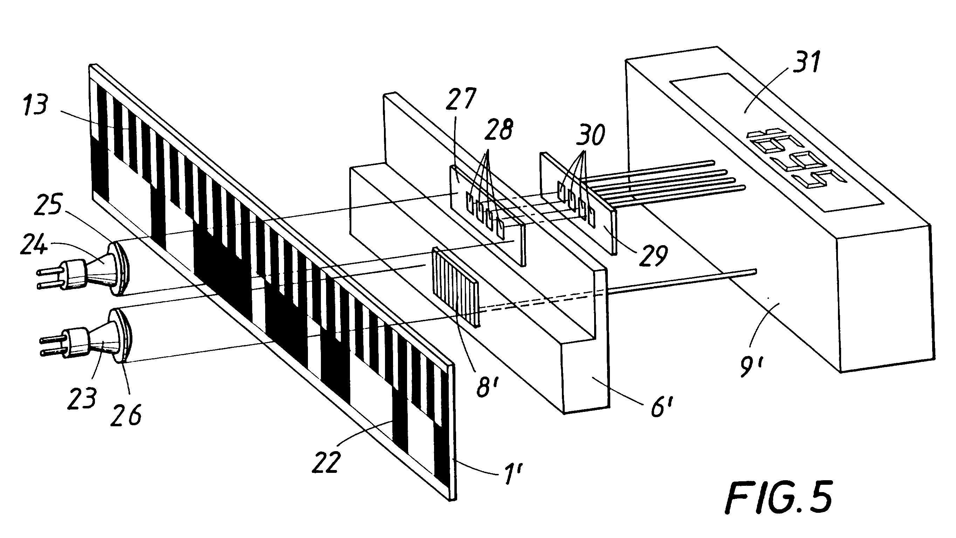

Um die Ablesegenauigkeit insbesondere im Stillstand zu erhöhen, entspricht nach Fig. 4 die Breite der Codierungsbits 19, 20 beim Codewort 2′ der zweifachen Breite der Einzelzeilen 18 des Zeilendetektors 8 nach Fig. 1. Die Codierungsbits 19, 20 können bei der Ablesung die Werte "1" bzw. "0" repräsentieren. Das bruchstückhaft wiedergegebene Codewort nach Fig. 4 würde 1 0 1 1 0 0 1 lauten. Zur Verbesserung der Unterscheidungsgenauigkeit sind aber zwischen die Codierungsbits 19, 20 Leerbits 21 eingefügt, die nur der besseren Unterscheidbarkeit halber in Fig. 4 schraffiert und nicht geschwärzt dargestellt wurden. Das nun gezeigte, etwa dem Codewort 2′ entsprechende Codewort wird vom Detektor als 0 1 0 0 0 1 0 1 0 0 0 0 0 1 0 abgelesen.

Nach Fig. 5 sind für die beiden Meßteilungsspuren 13, 22 des Maßstabes 1′ gesonderte Beleuchtungseinrichtungen 23, 24, z.B. Laserdioden oder andere Lampen mit nachgeordneteten, das austretende Licht richtenden Kondensoreinrichtungen 25, 26 bzw. Projektionseinrichtungen vorgesehen, wobei für die beiden Spuren 13, 22 auch eine gemeinsame Lichtquelle oder unterschiedliche Lichtquellen mit im Bedarfsfall nachgeschalteten Filtern, z.B. Polafiltern, vorgesehen werden können.

Die Meßteilungen 13, 22 sind nicht, wie dargestellt, vorne, sondern an der zur Abtasteinheit 6′ weisenden Seite des Maßstabkörpers 1′ angebracht. Dabei ist die Meßteilung 22 eine Absolutteilung mit ineinander verschachtelten Codewörtern und die Meßteilung 13 wieder eine Inkrementalteilung. Die Teilungskonstante kann für beide Teilungen bei Verwendung von Zeilendetektoren als Ableseeinrichtungen für beide Spuren an die Pixelbreite dieser Zeilendetektoren angepaßt sein. Die Maßstabspuren und die Elemente der Ableseeinheiten wurden in den Zeichnungsfiguren vielfach vergrößert dargestellt.

Die Ableseeinheit 6′ ist zur Einhaltung unterschiedlicher Abtastabstände zwischen Ableseeinrichtungen und Meßteilungen 13, 22 abgestuft. Für die Abtastung der Inkrementalspur 13 dient eine Abtastplatte 27 mit gegeneinander eine um Teilungsbruchteile der Inkrementalteilung versetzte Gitterteilung aufweisenden Abtastgittern 28, denen auf einem Träger 29 Fotoempfänger 30 zugeordnet sind, die vier jeweils um 90° gegeneinander phasenverschobene Abtastsignale erzeugen, aus denen in einer Auswertungseinheit durch paarweise Gegenschaltung der um 180° versetzten Signale zwei um 90° versetzte Sinussignale erzeugt werden. Diese Signale werden zur genauen Bestimmung der Lage der Abtasteinheit durch Phasenerkennung sowie bei schnellen Messungen für die Erzeugung von interpolierbaren Zählsignalen verwendet, die die Lageveränderung die gegenüber der im wesentlichen im Ruhezustand aus der Abtastung beider Spuren ermittelten Ruhe-Absolutposition und damit auch während der Verstellung die jeweilige Absolutposition definieren. Zur Einhaltung verschiedener Abtastabstände könnten auch der Maßstab an einer der beiden Meßteilungen abgestuft bzw. Maßstab 1′ oder Abtasteinheit 6′ aus verschieden dicken und gegeneinander der Dicke nach versetzten Teilen gebildet werden.

Bei einer seriellen Codierung, wie sie in Fig. 5 gezeigt wird, ist jede erfaßte und sich von der benachbarten Maßstabstelle um eine Pixel- bzw. Strichbreite unterscheidende Maßstabstelle durch ein bestimmtes Codewort definiert. Bezeichnet man die Anzahl der Zeilen des Detektors mit n, dann ergibt sich als Anzahl der unterscheidbaren Codeworte der Betrag von 2ⁿ, in der Praxis beispielsweise 2¹⁶.

Die Bestimmung des Meßpunktes bezüglich der Inkrementalsignale kann durch die Endflanke der ersten vollständig erfaßten Zeile des jeweiligen Codewortes erfolgen. Die Signale aus 8′ und 30 werden einer Auswertungseinheit 9′ zugeführt. Das Meßergebnis kann auf einer Anzeige 31 sichtbar gemacht werden und es ist auch möglich, die verarbeiteten Meßsignale einer Ausgabeeinrichtung und über diese einer Maschinen- oder Robotersteuerung bzw. Positioniereinrichtung zuzuführen.

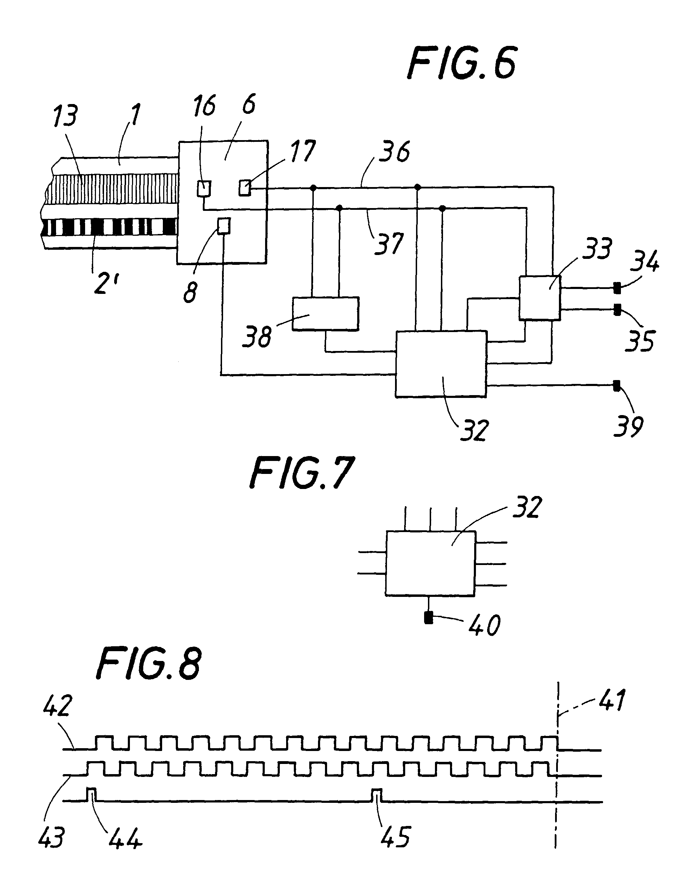

Um beim Start des Meßsystems oder nach einem entsprechenden Kommando, insbesondere bei Stillstand der Abtasteinheit 6 gegenüber dem Maßstab 1, eine nur Eingänge für Inkrementalsignale aufweisende Auswertungseinheit, z.B. eines Roboters oder einer Werkzeugmaschine, auf einen die Absolutposition kennzeichnenden Wert setzen zu können, ist eine Anpassungsschaltung vorgesehen, wie sie im Zusammenhang mit Fig. 6 weiter beschrieben wird.

Diese Anpassungsschaltung besteht im wesentlichen aus einem Rechner 32 und einer vom Rechner 32 gesteuerten Umsteuerlogik 33. Der Rechner 32 erfaßt die Signale der Ableseeinrichtungen 8, 16, 17 und damit die momentane Absolutposition der Abtasteinheit 6 und frägt aus seinem Speicher den zugeordneten, die Absolutposition kennzeichnenden Inkrementalzählwert ab. Dieser Zählwert wird über die entsprechend eingestellte Umsteuerlogik 33 auf Ausgänge 34, 35 und über diese auf dem Anschluß der weiter nicht dargestellten Auswertungseinheit dienende Schnittstellen gelegt. Die Zähleinrichtung bzw. Steuereinrichtung der Auswertungseinheit wird damit auf einen die Momentanposition kennzeichnenden, digitalen Zählwert gestellt.

Während der Ubertragung der Zählsignale bleibt eine Überwachungseinrichtung aktiv, die beim Ausführungsbeispiel als an die von den Ableseeinrichtungen 16, 17 für die Inkrementalspur 13 ausgehenden Leitungen 36, 37 angeschlossener Zähler 38 dargestellt wurde, der über den Rechner aus- und eingeschaltet und abgefragt werden kann. Bei einer Relativverstellung der Abtasteinheit gegenüber dem Maßstab 1 während der Signalübertragung vom Rechner 32 zu den Ausgängen 34, 35 erfaßt der Zähler 38 verstellrichtungsabhängig die dabei durch Abtastung der Inrekementalteilung 13 erzeugten Signale. Diese Signale bzw. der Zählerstand des Zählers 38 werden nach Beendigung der Übertragung des die ursprüngliche Absolutposition kennzeichnenden Signalzuges vom Rechner 32 erfaßt und über die Umsteuerlogik 33 der Auswertungseinheit zugeführt, so daß der Stand von deren Zähleinrichtung tatsächlich der momentanen Absolutposition entspricht. Anschließend steuert die Umsteuerlogik 33 um, so daß die Leitungen 36, 37 mit 34, 35 verbunden werden und die Auswertungseinheit unmittelbar die Inkrementalsignale erhält und verstellrichungsabhängig auswerten kann.

Im Speicher des Rechners 32 können noch ein oder mehrere Vorgabewerte gespeichert werden, die Absolutpositionen zugeordnet sind, wobei der Rechner diese z.B. in Form von Zählwerten gespeicherten Speicherwerte, bezogen auf die momentane Absolutposition erfaßt und bei Übereinstimmung des gespeicherten Absolutwertes mit dem momentanen Meßwert ein Referenzsignal auf einen Ausgang 39 abgibt. Es können auch mehrere solcher Absolutwerte vorgespeichert werden, wobei jeweils beim Auftreten der Übereinstimmung ein Referenzsignal erzeugt wird.

Fig. 7 zeigt eine Ausführungsvariante, bei der für den Rechner 32 ein Setzeingang 40 vorgesehen ist, über den an wählbarer Stelle der Abtasteinheit 6 gegenüber dem Maßstab 1 ein Befehl eingegeben werden kann, durch den ein diese Stelle kennzeichnender Absolutwert in einem eigenen Speicher des Rechners 32 gespeichert wird. Der Rechner 32 enthält hier eine Differenzbildungsstufe, die vor der Signalübertragung zur Auswertungseinheit den Speicherwert von dem die momentane Absolutlage kennzeichnenden Wert subtrahiert, so daß die Auswertungseinheit ihre Messung auf den durch Betätigung des Setzeinganges 16 z.B. mittels eines Setzschalters gesetzten Nullpunkt und nicht auf den Nullpunkt des Absolutsystems an sich bezieht.

Es besteht auch die Möglichkeit, durch Auswahl der Vorgabewerte für Absolutpositionen, an denen Referenzsignale zu erzeugen sind, eine gedachte Abstandscodierung der virtuellen Referenzmarken vorzunehmen, also die Absolutlage jeder Referenzmarke durch ihren Abstand von einer benachbarten Referenzmarke und die Meßrichtung (Verstellrichtung) zu definieren. In diesem Fall kann nach Fig. 8 eine bestimmte Absolutposition 41 dadurch definiert werden, daß an die Auswertungseinheit vom Rechner 32 Zählsignale 42, 43 (die Signale aus den Leitungen 36, 37 vortäuschen) und, zugeordnet, Referenzsignale (44, 45) übertragen werden. Die Signalzüge 42, 43 geben den Abstand zwischen den der Meßstelle 41 nächstliegenden, durch die Speicherwerte bestimmten, aufeinanderfolgenden, gedachten Referenzmarken 44, 45 und dann den Abstand von der Meßstelle 41 von der nächstliegenden, durch das Signal 45 definierten Referenzstelle an und bestimmen auch jene Verstellrichtung der Abtasteinheit 6 gegenüber dem Maßstab, die bei einem Inkrementalsystem mit echten, abstandscodierten Referenzmarken für die Erzeugung der genannten Signale tatsächlich notwendig wäre.

In den Ausführungsbeispielen wurden jeweils Linearmeßsysteme beschrieben. Winkelmeßsysteme lassen sich in entsprechender Weise aufbauen, wobei bei sinngemäß gleichbleibenden Abtasteinheiten die Linearmaßstäbe durch Meßteilungen auf Scheiben, Kreisringen oder Trommeln ersetzt werden.

## Patentansprüche

1. Längen- oder Winkelmeßsystem mit einem Maßstab (1, 1') dessen Meßteilung absolut seriell codierte Meßteilungselemente (2, 3, 4, 5, 22) aufweist, die unterschiedliche, in Meßrichtung aufeinanderfolgende Codewörter (4, 22) bilden, einer in Meßrichtung relativ zum Maßstab verstellbaren Abtasteinheit (6, 6') mit mehrzeiligen Ableseeinrichtungen (8, 8') zur Erzeugung von Meßsignalen (2a, 2b, 3a) aus der Ablesung der Meßteilungselemente, wobei die Ableseeinrichtungen (8, 8') in jeder Relativstellung der Abtasteinheit (6, 6') zum Maßstab wenigstens ein Codewort (4, 22) vollständig erfassen und eine Auswertungseinrichtung (9, 9'), die aus den Meßsignalen der Ableseeinrichtungen die Momentanstellung der Abtasteinheit (6, 6') zum Maßstab (1, 1') abolsut bestimmt, dadurch gekennzeichnet, daß der Maßstab (1, 1') eine Inkrementalspur (13) aufweist, eine Ableseeinrichtung (8, 14 - 17, 28 - 30) für die Inkrementalteilung (13) ebenfalls in jeder Relativstellung der Abtasteinheit (6, 6') zum Maßstab (1, 1') ein Inkremental-Meßsignal (14a, 15a) erzeugt und die Auswertungseinheit (9, 9', 32) nur nach entsprechender Ansteuerung unterhalb einer vorgebbaren Verstellgeschwindigkeit der Abtasteinheit (6, 6'), insbesondere bei zumindest im wesentlichen stillstehender Abtasteinheit, bei Meßbeginn oder nach Betriebsunterbrechungen die momentane Absolutposition aus den Signalen beider Ableseeinrichtungen (8, 16, 17) bestimmt und beim weiteren Meßvorgang lediglich die Abtastsignale der Inkrementalteilung (13) verstellrichtungsabhängig auswertet.

2. Meßsystem nach Anspruch 1, dadurch gekennzeichnet, daß jedes Codewort (4) aus einer die jeweilige Maßstabstelle kennzeichnenden, seriellen Codierung (2) und einem vorgeordneten, für alle Codewörter gleichen Startzeichen (3) besteht, wobei die Auswertungseinrichtung die Relativlage dieses Startzeichens (3) zum Detektor (8, 8′) aus der bei der Abtastung einer Kante des Startzeichens (3) im Detektor auftretenden Signalflanke (12) erfaßt und zur Lagebestimmung der Ableseeinrichtungen gegenüber den Meßteilungen (2, 4, 3, 13) auswertet.

3. Meßsystem nach den Ansprüchen 1 und 2, dadurch gekennzeichnet, daß die Auswertungseinrichtung (9) zur genauen Lagebestimmung für eine Kantenauswertung der Signalflanke über Triggerpegel ausgebildet ist.

4. Maßsystem nach den Ansprüchen 1 - 3, dadurch gekennzeichnet, daß in einer Parallelspur zu den die Codewörter (4, 22) aufweisenden, absolut codierten Spur (5) eine durchgehende Inkrementalteilung (13) vorgesehen und für sie zur Erzeugung gegeneinander phasenverschobener Abtastsignale gesonderte Abtasteinheiten (14 - 17, 28, 30) mit gegeneinander um Teilungsbruchteile versetzten Abtastgittern (14, 15, 28) vorgesehen sind.

5. Meßsystem nach einem der Ansprüche 1 - 4, dadurch gekennzeichnet, daß die Breite der Codierungsbits (18) der Codewörter ein Vielfaches, z.B. das Zweifache der Zellen-(Pixel-)breite des Detektors (8) beträgt.

6. Meßsystem nach Anspruch 5, dadurch gekennzeichnet, daß in der codierten Meßteilung (2′) zwischen alle aufeinanderfolgenden, ein Codewort bestimmenden Codierungsbits Leerbits (Stege 21) eingefügt sind, deren Breite jener der Codierungsbits (19, 20) entsprechen kann.

7. Meßsystem nach einem der Ansprüche 1 - 6, dadurch gekennzeichnet, daß als Beleuchtungseinrichtung für die Meßteilungen (5, 13, 22) ein oder mehrere Laserdioden (23, 24) bzw. eine Kombination aus Laserdioden und inkohärenten Lichtquellen vorgesehen sind.

8. Meßsystem nach einem der Ansprüche 1 - 7, dadurch gekennzeichnet, daß zur Erzeugung optimal auswertbarer Signale eine Abtastung der codierten und inkrementellen Meßteilungselemente (13, 22) nach unterschiedlichen Abtastprinzipien und/oder unter Einhaltung unterschiedlicher Abtastabstände oder -wege vorgesehen ist.

9. Meßsystem nach Anspruch 8, dadurch gekennzeichnet, daß die in zwei Ablesespuren vorgesehenen Meßteilungselemente (13, 22) in unterschiedliche Abtastabstände bestimmenden Parallelebenen am entsprechend abgestuften oder aus zwei zugeordneten Einzelelementen gebildeten Maßstabkörper (1') angebracht sind.

10. Meßsystem nach Anspruch 8, dadurch gekennzeichnet, daß die beiden Ableseeinheiten (8, 27, 28) auf einer gemeinsamen Abtasteinheit (6') in Richtung des Abtastabstandes vom Maßstab gegeneinander abgestuft versetzt angeordnet sind.

11. Meßsystem nach einem der Ansprüche 1 - 10, dadurch gekennzeichnet, daß zur optoelektronischen Abtastung durch die Ableseeinheit für die die Absolutteilung (22) aufweisende Maßstabspur ein Zeilendetektor (8') vorgesehen ist und die Ableseeinheit zur Ablesung der Inkrementalteilung (13) wenigstens eine Abtastplatte (27) mit gegeneinander um Teilungsbruchteile versetzten Gitterteilungen (28) und durch den Maßstab (1') und diese versetzten Gitterteilungen beleuchtete Fotoempfänger (30) aufweist.

12. Meßsystem nach einem der Ansprüche 1 - 11, dadurch gekennzeichnet, daß die als Zeilendetektoren für die optoelektronische Abtastung vorgesehenen CCD-Chips oder Fotodiodenarrays (8') gegenüber dem Lichteinfallswinkel im Brewster-Winkel geneigt angeordnet sind und über die Meßteilung (22) mit polarisiertem Licht beleuchtet werden.

13. Meßsystem nach einem der Ansprüche 1 - 12, dadurch gekennzeichnet, daß eine zweite, absolut ident mit der ersten Spurt codierte Absolut-Meßteilungsspur mit zugeordneter, eigener Ableseeinrichtung vorgesehen und gegenüber der ersten Spur um eine halbe Pixelbreite versetzt angebracht ist, wobei eine vom Abtastsignal der Inkrementalteilung gesteuerte Entscheidungslogik in Zwischenstellungen der Ableseeinheiten bestimmt, nach welcher Ableseeinheit und damit Meßteilungsspur im Momentanfall der Meßwert ermittelt wird.

14. Meßsystem nach Anspruch 8 und einem oder mehreren der übrigen Ansprüche, dadurch gekennzeichnet, daß für einen Anschluß des Meßsystems an eine Eingänge für von einem inkrementalen Meßsystem stammende Signale aufweisende Auswertungseinheit eine Anpassungsschaltung mit einem Rechner (32) vorgesehen ist, der aus den ihm zugeführten Meßsignalen der Ableseeinrichtungen (8, 16, 17) die die Momentanposition der Abtasteinheit kennzeichnende Anzahl von Inkrementalsignalen bestimmt und in entsprechender Signalform an die Ausgänge (34, 35, 39) der Auswertungseinheit überträgt.

15. Meßsystem nach Anspruch 14, dadurch gekennzeichnet, daß eine Umsteuerlogik (33) vorgesehen ist, die nach Einschaltung des Meßsystems die Ableseeinheiten (8, 16, 17) mit der Anpassungsschaltung und, nach Übertragung der die Momentanposition kennzeichnenden Inkrementalsignale (42, 43) von der Anpassungsschaltung zur Auswerteeinheit, die Ableseeinrichtung für die Inkrementalteilung (16, 17) mit der Auswertungseinheit verbindet.

16. Meßsystem nach Anspruch 14 oder 15, dadurch gekennzeichnet, daß die Anpassungsschaltung eine auf Relativverstellungen der Abtasteinheit (6) gegenüber dem Maßstab (1) während der Erfassung und der Übertragung der die Momentanposition kennzeichnenden Signale zur Auswertungseinheit empfindliche Überwachungseinrichtung mit einer die bei einer solchen Relativverstellung an der Inkrementalteilung erzeugten Signale verstellrichtungsabhängig erfassenden Zähleinrichtung (38) und zugeordnet eine Rechner-Korrekturstufe (32) zur Abgabe entsprechender Korrektursignale an die Auswertungseinheit aufweist.

17. Meßsystem nach einem der Ansprüche 14 - 16, dadurch gekennzeichnet, daß die Anpassungsschaltung einen mit dem Rechner (32) verbundenen Speicher zur Vorgabe von Absolutpositionen aufweist, der Rechner (32) die die Momentanposition kennzeichnenden Signale mit den Vorgabewerten vergleicht und bei Übereinstimmung ein Referenzsignal erzeugt und an einem Referenzsignaleingang (39) der Auswertungseinheit legt.

18. Meßsystem nach Anspruch 17, dadurch gekennzeichnet, daß im Speicher die Vorgabewerte für Absolutpositionen, an denen Referenzsignale (44, 45) zu erzeugen sind, im Sinne einer Abstandscodierung mit unterschiedlichen Abstandswerten voneinander gespeichert sind.

19. Meßsystem nach Anspruch 18, dadurch gekennzeichnet, daß bei Verwendung einer für die Lagebestimmung über von abstandscodierten Referenzmarken stammende Referenzsignale ansteuerbaren Auswertungseinheit der Rechner (32) der Anpassungsschaltung die Momentanposition durch Referenzsignale (44, 45) für die beiden an der einen Seite der tatsächlichen Meßstelle (41) aufeinanderfolgenden, durch die Speicherwerte definierten Referenzpunkte, einen dem Abstand dieser Referenzpunkt entsprechenden Inkrementalsignalzug (42, 43), und einen den Abstand der Meßstelle von dem näheren dieser durch die Speicherwerte definierten Referenzpunkte angebenden Inkrementalsignalzug definiert.

20. Meßsystem nach einem der Ansprüche 14 - 19, dadurch gekennzeichnet, daß der Rechner (32) einen über einen Schalter (40) auf den momentanen Absolut-Meßwert oder einen wählbaren Wert setzbaren Speicher und eine Differenzbildungsstufe aufweist, die fortlaufend die Differenz aus dem jeweiligen Absolut-Meßwert und dem Speicherwert bildet, so daß die Anpassungsschaltung an die Auswertungseinheit Signale abgibt, die auf eine wählbare Nullposition des Meßsystems bezogen sind.

## Claims

1. Length or angle measuring system having a measuring scale body (1, 1'), whose measuring scale comprises absolute serial coded measuring scale elements (2, 3, 4, 5, 22) which form different code words (4, 22) which are sequential in the measuring direction, a scanning unit (6, 6') which can be adjusted in the measuring direction relative to the measuring scale body and comprises multi-line reading devices (8, 8') for the purpose of producing measurement signals (2a, 2b, 3a) from the reading of the measuring scale elements, wherein the reading devices (8, 8') fully detect in each relative position of the scanning unit (6, 6') with respect to the measuring scale body at least one code word (4, 22) and an evaluating unit (9, 9') ascertains absolutely from the measurement signals of the reading devices the instantaneous position of the scanning unit (6, 6') with respect to the measuring scale body (1, 1'), characterised in that the measuring scale body (1, 1') comprises an incremental track (13), in that a reading device (8, 14 - 17, 28-30) for the incremental scale (13) likewise in each relative position of the scanning unit (6, 6') with respect to the measuring scale body (1, 1') produces an incremental measurement signal (14a, 15a) and in that at the commencement of the measuring process or after interruptions in the operation the evaluating unit (9, 9', 32) ascertains the instantaneous absolute position from the signals of the two reading devices (8, 16, 17) only after an appropriate control process below a predeterminable rate of adjustment of the scanning unit (6, 6'), in particular in the case of a scanning unit which is at least substantially stationary and during the further measuring process merely evaluates the scanning signals of the incremental scale (13) dependent upon the direction of adjustment.

2. Measuring system according to claim 1, characterised in that each code word (4) consists of a serial coding (2), which denotes the respective position on the measuring scale body, and a preceding start indicator (3) identical for all code words, wherein the evaluating unit detects the relative position of this start indicator (3) with respect to the detector (8, 8') from the signal edge (12) which occurs in the detector when scanning an edge of the start indicator (3) and evaluates said position for the purpose of ascertaining the position of the reading devices with respect to the measuring scales ( 2, 4, 3, 13).

3. Measuring system according to claims 1 and 2, characterised in that the evaluating unit (9) is designed for the purpose of ascertaining precisely the position in order to evaluate the edge of the signal edge by means of a trigger level.

4. Measuring system according to claims 1 - 3, characterised in that a continuous incremental scale (13) is provided in a track which is parallel to the absolute coded track (5) which comprises the code words (4, 22) and for which for the purpose of producing mutually out-of-phase scanning signals separate scanning units (14 - 17, 28, 30) are provided with scanning grids (14, 15, 28) which are mutually offset by fractions of the scale.

5. Measuring system according to any one of claims 1 - 4, characterised in that the width of the coding bits (18) of the code words amounts to a multiple, e.g. twice the line (pixel) width of the detector (8).

6. Measuring system according to claim 5, characterised in that in the coded measuring scale (2') between all sequential coding bits, which determine a code word, empty bits (spacers 21) are inserted and the width of said empty bits can correspond to that of the coding bits (19, 20).

7. Measuring system according to any of claims 1 - 6 characterised in that one or a plurality of laser diodes (23, 24) or a combination of laser diodes and incoherent light sources are provided as an illuminating device for the measuring scales (5, 13, 22).

8. Measuring system according to any one of claims 1 - 7, characterised in that for the purpose of producing signals which can be evaluated to an optimum the coded and incremental measuring scale elements (13, 22) are scanned according to different scanning principles and/or whilst maintaining different scanning distances or ranges.

9. Measuring system according to claim 8, characterised in that the measuring scale elements (13, 22) provided in two reading tracks are arranged in parallel planes determining different scanning distances at the measuring scale body (1') which is correspondingly stepped or formed from two associated individual elements.

10. Measuring system according to claim 8, characterised in that the two reading units (8, 27, 28) are arranged on a common scanning unit (6') and mutually offset and stepped in the direction of the scanning distance from the measuring scale body.

11. Measuring system according to any one of claims 1 - 10, characterised in that a line detector (8') is provided for the optoelectronic scanning process by means of the reading unit for the measuring scale body track comprising the absolute scale (22) and in that the reading unit comprises for the purpose of reading the incremental scale (13) at least one scanning plate (27) having grid divisions (28) mutually offset by fractions of the scale and photo-receivers (30) which are illuminated through the measuring scale body (1') and these offset grid divisions.

12. Measuring system according to any one of claims 1 - 11, characterised in that the CCD chips or arrays of photo-diodes (8') provided as line detectors for the optoelectronic scanning process are arranged inclined with respect to the angle of incidence of light at the Brewster angle and are illuminated with polarised light by way of the measuring scale (22).

13. Measuring system according to any one of claims 1 - 12, characterised in that a second absolute measuring scale track coded absolutely identical to the first track is provided with an associated dedicated reading device and is arranged offset by half one pixel width with respect to the first track, wherein decision logic controlled by the scanning signal of the incremental scale in the intermediate positions of the reading units determines according to which reading unit and thus which measuring scale track in the instantaneous case the measured value is to be ascertained.

14. Measuring system according to claim 8 and one or several of the remaining claims, characterised in that for the purpose of connecting the measuring system to an evaluating unit comprising inputs for signals originating from an incremental measuring system a matching circuit is provided with a computer (32) which determines from the measurement signals, which are produced by the reading devices (8, 16, 17) and directed to the computer, the number of incremental signals which denotes the instantaneous position of the scanning unit and transmits the information in a relevant signal form to the outputs (34, 35, 39) of the evaluating unit.

15. Measuring system according to claim 14, characterised in that a switching logic unit (33) is provided which after switching on the measuring system connects the reading units (8, 16, 17) to the matching circuit and after transmitting the incremental signals (42, 43), which denote the instantaneous position, from the matching circuit to the evaluating unit, connects the reading device for the incremental scale (16, 17) to the evaluating unit.

16. Measuring system according to claim 14 or 15, characterised in that the matching circuit comprises a monitoring device which is sensitive to the relative positions of the scanning unit (6) with respect to the measuring scale body (1) during the detection of the signals which denote the instantaneous position and the transmission of said signals to the evaluating unit, the said monitoring device having a counting device (38) which detects dependent upon the direction of adjustment the signals produced in the case of such a relative adjustment at the incremental scale and correspondingly a computer correcting stage (32) for the purpose of outputting relevant correcting signals to the evaluating unit.

17. Measuring system according to any one of claims 14 - 16, characterised in that the matching circuit comprises a memory connected to the computer (32) for the purpose of outputting absolute positions, the computer (32) compares the signals which denote the instantaneous position with the output values and in the case of a match produces a reference signal which is provided at a reference signal input (39) of the evaluating unit.

18. Measuring system according to claim 17, characterised in that the output values for the absolute positions, at which reference signals (44, 45) are to be produced, are stored separately in the memory in the form of a distance coding with different distance values.

19. Measuring system according to claim 18, characterised in that when using an evaluating unit which can be controlled for the purpose of ascertaining the position by way of reference signals originating from distance coded reference marks the computer (32) of the matching circuit defines the instantaneous position by virtue of reference signals (44, 45) for the two reference points, which are sequential on one side of the actual measuring site (41) and are defined by the stored values, by virtue of an incremental signal train (42, 43) corresponding to the distance of these reference point(s) and by virtue of an incremental signal train indicating the distance of the measuring site from the closer of the two reference points defined by the stored values.

20. Measuring system according to any one of claims 14 - 19, characterised in that the computer (32) comprises a memory which can be set by way of a switch (40) to the instantaneous absolute measured value or an optional value and comprises a difference formation stage which continuously forms the difference from the respective absolute measured value and the stored value, so that the matching circuit outputs to the evaluating unit signals which relate to an optional zero position of the measuring system.

## Revendications

1. Système de mesure de longueurs ou d'angles, comportant une règle graduée (1, 1') dont la graduation de mesure présente des éléments de graduation de mesure (2, 3, 4, 5, 22), codés de façon sérielle et absolue, constituant des mots de code (4, 22) différents, se suivant les uns les autres dans la direction de la mesure, avec une unité d'exploration (6, 6'), déplaçable de façon réglée dans la direction de la mesure, par rapport à la règle graduée, et portant des dispositifs de lecture (8, 8') à plusieurs lignes, destinés à produire des signaux de mesure (2a, 2b, 3a) à partir de la lecture des éléments de graduation de mesure, les dispositifs de lecture (8, 8') appréhendant, pour chaque position relative de l'unité d'exploration (6, 6') par rapport à la règle graduée, au moins un mot de code (4, 22) en totalité, et un dispositif d'évaluation (9, 9') déterminant de façon absolue, à partir des signaux de mesure venant des dispositifs de lecture, la position instantanée de l'unité d'exploration (6, 6') par rapport à la règle graduée (1, 1'), caractérisé en ce que la règle graduée (1, 1') présente une piste incrémentale (13), un dispositif de lecture (8, 14 à 17, 28 à 30) produisant un signal de mesure incrémental (14a, 15a) pour la division incrémentale (13), également à chaque position relative de l'unité d'exploration (6, 6') par rapport à la règle graduée (1, 1'), et l'unité d'évaluation (9, 9', 32) déterminant, seulement après une commande correspondante, en évoluant à une vitesse inférieure à une vitesse de réglage, pouvant être allouée, de l'unité d'exploration (6, 6') , en particulier pour une unité d'exploration placée au moins pratiquement à l'arrêt, au moment du début de la mesure ou bien après survenance d'interruptions de mesure, quelle est la position absolue instantanée, en opérant à partir des signaux venant des deux dispositifs de lecture (8, 16, 17) et, lors de la continuation du processus de mesure, seuls sont évalués, en fonction de la direction de déplacement réglée, les signaux d'exploration venant de la division incrémentale (13).

2. Système de mesure selon la revendication 1, caractérisé en ce que chaque mot de code (4) est constitué d'un codage sériel (2), caractérisant le point spécifique sur la règle graduée, et d'un caractère de départ (3) placé à l'avant, identique pour tous les mots de code, le dispositif d'évaluation appréhendant la position relative de ce caractère de départ (3) par rapport au détecteur (8, 8') à partir des flancs de signaux (12) produits dans le détecteur lors de l'exploration d'un bord du caractère de départ (3) et effectuant une évaluation en vue de déterminer la position des dispositifs de lecture vis-à-vis des graduations de mesure (2, 4, 3, 13).

3. Système de mesure selon les revendications 1 et 2, caractérisé en ce que le dispositif d'évaluation (9), réalisé pour assurer une détermination précise de position, est conçu pour assurer une évaluation des bords sur les flancs de signaux par le biais du dépassement d'un niveau de déclenchement.

4. Système de mesure selon les revendications 1 à 3, caractérisé en ce que, dans une piste, parallèle par rapport à la piste (5), codée de façon absolue et présentant les mots de code (4, 22), est prévue une graduation incrémentale (13) ininterrompue et pour celle-ci sont prévues, pour assurer la génération de signaux d'exploration déphasés les uns par rapport aux autres, des unités d'exploration (14 à 17, 28, 30) séparées, équipées de grilles d'exploration (14, 15, 28) décalées les unes par rapport aux autres de la valeur de fractions de la graduation.

5. Système de mesure selon l'une des revendications 1 à 4, caractérisé en ce que la largeur des bits de codage (18) des mots de code est un multiple, par exemple le double, de la largeur (en pixels) des lignes du détecteur (8).

6. Système de mesure selon la revendication 5, caractérisé en ce que des bits vides (barres 21), dont la largeur peut correspondre à celle des bits de codage (19, 20) dans la graduaticn de mesure codée (2'), sont insérés entre tous les bits de codage se suivant et déterminant un mot de code,.

7. Système de mesure selon l'une des revendications 1 à 6, caractérisé en ce qu'une ou plusieurs diodes laser (23, 24), respectivement une combinaison de diodes laser et de sources à lumière incohérente, sont prévues comme dispositif d'illumination pour les graduations àe mesure (5, 13, 22).

8. Système de mesure selon l'une des revendications 1 à 7, caractérisé en ce qu'une exploration des éléments de graduation de mesure (13, 22) codés et incrémentaux, faite selon différents principes d'exploration et/ou en respectant différents espacements ou cheminements dans l'exploration, est prévue pour assurer la génération de signaux évaluables de façon optimale.

9. Système de mesure selon la revendication 8, caractérisé en ce que les plans parallèles, qui déterminent des éléments de graduation de mesure (13, 22) prévus dans deux pistes de lecture et respectant des espacements d'exploration différents, sont placés sur des corps de règle graduée (1'), présentant un étagement correspondant ou bien constitués de deux éléments individuels associés.

10. Système de mesure selon la revendication 8, caractérisé en ce que les deux unités de lecture (8, 27, 28) sont disposées sur une unité d'exploration (6') commune, de façon décalée et étagée l'une par rapport à l'autre, dans la direction de l'espacement d'exploration vis de la règle graduée.

11. Système de mesure selon l'une des revendications 1 à 10, caractérisé en ce que, pour obtenir une exploration optoélectronique au moyen de l'unité de lecture, pour la piste de règle graduée présentant la graduation absolue (22), est prévu un détecteur de lignes (8') et l'unité de lecture destinée à lire la graduation incrémentale (13) présente au moins une plaque d'exploration (27) portant des graduations en grille (28) décalées les unes par rapport aux autres de la valeur de fractions de graduation et avec des photorécepteurs (30) illuminés en passant à travers la règle graduée (1') et à travers ces divisions de graduation décalées.

12. Système de mesure selon l'une des revendications 1 à 11, caractérisé en ce que les puces électroniques de type CCD ou les matrices de photodiodes (8'), prévues comme détecteurs de lignes pour l'exploration optoélectronique, sont disposées inclinées par rapport à l'angle d'incidence de la lumière, dans les limites de l'angle de Brewster, et sont illuminées en lumière polarisée, en traversant la graduation de mesure (22).

13. Système de mesure selon l'une des revendications 1 à 12, caractérisé en ce qu'une deuxième piste de graduation de mesure absolue, codée de façon absolument identique à la première piste, est prévue, avec un dispositif de lecture associé, propre, et est montée de façon décalée par rapport à la première piste, le décalage étant de la valeur d'une demi-largeur de pixel, une logique de décision, commandée par le signal d'exploration de la graduation incrémentale, déterminant dans des positions intermédiaires des unités de lecture selon quelle unité de lecture et ainsi quelle piste de graduation de mesure la valeur de mesure va être déterminée dans le cas actuel.

14. Système de mesure selon la revendication 8 et une ou plusieurs des autres revendications, caractérisé en ce que, pour effectuer un raccordement du systéme ce mesure à une unité d'évaluation présentant des entrées pour les signaux provenant d'un système de mesure incrémental, est prévu un circuit d'adaptation équipé d'un ordinateur (32) qui détermine, à partir des signaux de mesure lui étant amenés et venant des dispositifs de lecture (8, 16, 17), le nombre, caractérisant la position instantanée de l'unité de mesure, de signaux incrémentaux et le transmet, sous une forme de signal correspondante, aux entrées (34, 35, 39) de l'unité d'évaluation.

15. Système de mesure selon la revendication 14, caractérisé en ce qu'est prévue une logique de commutation de commande (33) qui, après mise en service du système de mesure, relie les unités de lecture (8, 10, 16, 17) au circuit d'adaptation et, après transmission, du circuit d'adaptation à l'unité d'évaluation, des signaux incrémentaux (42, 43) caractérisant la position instantanée, relie le dispositif de lecture, destiné à la graduation incrémentale (16, 17), à l'unité d'évaluation.

16. Système de mesure selon la revendication 14 ou 15, caractérisé en ce que le circuit d'adaptation présente un dispositif de surveillance sensible à des positions relatives de l'unité d'exploration (6) par rapport à la règle graduée (1), pendant l'acquisition et la transmission à l'unité d'évaluation des signaux caractérisant la position instantanée, le dispositif de surveillance comportant un dispositif de comptage (38) qui appréhende, de façon dépendante de la direction de déplacement réglée, les signaux générés sur la graduation incrémentale lors d'un tel déplacement réglé relatif et présente, lui étant associé, un étage correcteur pour ordinateur (32), destiné à fournir des signaux de correction correspondants à l'unité d'évaluation.

17. Système de mesure selon l'une des revendications 14 à 16, caractérisé en ce que le circuit d'adaptation présente une mémoire, reliée à l'ordinateur (32), pour allouer des positions absolues, l'ordinateur (32) comparant les signaux caractérisant la position instantanée avec les valeurs allouées et, en cas de coïncidence, produisant un signal de référence et l'appliquant à une entrée de signal de référence (39) de l'unité d'évaluation.

18. Système de mesure selon la revendication 19, caraccérisé en ce que, dans la mémoire sont stockées, avec des valeurs d'espacement différentes les unes des autres, les valeurs d'allocation des positions absolues auxquelles des signaux de référence (44, 45) doivent être produits, dans le sens d'un codage par espacements, construit avec des valeurs d'espacement différentes.

19. Système de mesure selon la revendication 18, caractérisé en ce que, en cas d'utilisation d'une unité d'évaluation, pouvant être commandée, pour assurer la détermination de position, par l'intermédiaire de signaux de référence provenant de marques de référence à codage par espacements, l'ordinateur (32) du circuit d'adaptation définit premièrement la position instantanée au moyen de signaux de référence (44, 45) valant pour les deux points de référence, définis par les valeurs mises en mémoire et se succédant, sur un côté de l'emplacement de mesure (41) effectif, définit deuxièmement un train de signaux incrémentaux (42, 43) correspondant à l'espacement de ces point de référence, et définit troisièmement un train de signaux incrémentaux indiquant l'espacement entre le point de mesure et le point de référence suivant parmi ces points de référence définis au moyen des valeurs mémorisées.

20. Système de mesure selon l'une des revendications 14 à 19, caractérisé en ce que l'ordinateur (32) présente une mémoire pouvant être fixée, par un interrupteur (40), pour prendre la valeur de mesure absolue momentanée ou bien une valeur pouvant être sélectionnée, et présente un étage formateur de différence qui constitue de façon continue la différence entre la valeur de mesure absolue respective et la valeur en mémoire, de manière que le circuit d'adaptation envoie à l'unité d'évaluation des signaux se référant à une position de zéro, pouvant être choisie, du système de mesure.
